# EUROPÄISCHE PATENTANMELDUNG

(11) **EP 2 818 576 A1**
(43) Veröffentlichungstag der Anmeldung: **31.12.2014**
(21) Anmeldenummer: 14168391.2
(22) Anmeldetag: 15.05.2014
(51) Int. Cl.: C23C 14/54, C23C 14/56, C23C 16/54, C23C 16/46

(54) **Verfahren zum Kühlen eines bandförmigen Substrates**

(30) Priorität: 27.06.2013 DE 102013212395
(71) Anmelder: Fraunhofer-Gesellschaft zur Förderung der angewandten Forschung e.V., 80686 München (DE)
(72) Erfinder: Guenther, Steffen, 01309 Dresden (DE); Vogt, Tobias, 01129 Dresden (DE)

(57) **Zusammenfassung**

Die Erfindung betrifft ein Verfahren zum Kühlen eines innerhalb einer Vakuumkammer (11; 12) angeordneten bandförmigen Substrates (10), welches eine Kühlwalze (15) teilweise umschlingt, wobei die nicht mit der Kühlwalze (15) in Kontakt gelangende Oberfläche des Substrates (10) in einem Bereich, in welchem das Substrat (10) die Kühlwalze (15) berührt, mit Partikeln beaufschlagt wird und wobei ein dampf- oder gasförmiges Medium auf einen vom bandförmigen Substrat (10) nicht umschlungenen Oberflächenbereich der Kühlwalze (15) strömt. Erfindungsgemäß wird die Kühlwalze (15) auf eine Temperatur gekühlt, bei der zumindest Bestandteile des auf die Kühlwalze (15) auftreffenden dampf- oder gasförmigen Mediums in den festen Aggregatzustand übergehen.

## Beschreibung

Die Erfindung betrifft ein Verfahren zum Kühlen eines bandförmigen Substrates, das während des Beschichtens oder Ätzens eines bandförmigen Substrates zur Anwendung gelangen kann.

### Stand der Technik

In Vakuumanlagen zum Beschichten oder Ätzen von bandförmigen Substraten wird oftmals eine Kühlwalze dazu verwendet, eine thermische Schädigung des Substrates während des Prozesses zu vermeiden. Die während eines solchen Prozesses in das Substratmaterial eingetragene Energie muss dazu vom Substrat auf die Kühlwalze übertragen werden. Dabei spielt der Wärmeübergang zwischen Substrat und Kühlwalze eine wichtige Rolle. Dieser Wärmeübergang wird unter anderem durch den Festkörperkontakt zwischen den Oberflächen von Substrat und Kühlwalze bestimmt. Es ist bekannt, dass dieser Festkörperkontakt nur einen geringen Wärmeübergangskoeffizienten generieren kann, da aufgrund der Rauheit der sich berührenden Oberflächen ein Kontakt nur punktuell stattfindet.

Beim Beschichten von Kunststofffolien bildet sich darüber hinaus manchmal ein höherer Wärmeübergangskoeffizient aus, der aus einem sich zwischen den Oberflächen von Substrat und Kühlwalze aufbauenden, wärmeleitenden Gaspolster resultiert. Solch ein Gaspolster kann beispielsweise infolge des Entweichens von Wasserdampf aus einer Kunststofffolie entstehen. Hierzu sei angemerkt, dass einigen Kunststoffen die Eigenschaft inne ist, eine gewisse Menge an Wasser absorbieren zu können, welche bei Temperaturerhöhung wieder desorbiert wird. Beim Beschichten von Kunststoffen mit einer geringen Wasserabsorption bzw. bei anderen nicht Wasser desorbierenden Substratarten, wie beispielsweise Metallfolien und Metallbändern, kann sich kein solches Wasserdampfpolster ausbilden. Der Wärmeübergang zwischen Kühlwalze und Substrat ist dann nur in sehr geringem Umfang möglich. Es können deshalb Überhitzungen, Wärmeschäden oder Prozessinstabilitäten entstehen.

Es ist bekannt zum Erhöhen des Wärmeüberganges ein Gas direkt in den Bereich zwischen Kühlwalze und einlaufendem Substrat einzublasen (DE 198 53 418 A1, US 5,076,203 A). Nachteilig hierbei sind das Einbringen einer undefinierten Menge von Gas zwischen die Oberflächen von Substrat und Kühlwalze sowie der hohe Verlust seitlich abströmenden Gases. Weiterhin kann dieses Verfahren nur bei schnelllaufenden Prozessen eingesetzt werden, da ansonsten nur unzureichende Gasmengen zwischen den Oberflächen eingefangen werden. Bei langsam laufenden Prozessen verbleibt das Gas nicht am benötigten Ort, sondern diffundiert aus dem Bereich heraus und wird von den Vakuumpumpen der Prozesskammer abgepumpt. Die Wirksamkeit dieses Verfahrens ist somit vergleichsweise gering. Außerdem besteht teilweise eine Einschränkung hinsichtlich der Substratauswahl, wie beispielsweise bei den aus US 5,076,203 A bekannten Verfahren, die auf Kunststofffolien limitiert sind.

Aus DE 10 2004 050 821 A1 ist es weiterhin bekannt, durch die Oberfläche der Kühlwalze hindurch ein Fluid in den Spalt zwischen Kühlwalze und Substrat zu pressen und aus benachbarten Bereichen wieder abzusaugen, was ebenfalls zu einer Verbesserung des thermischen Kontaktes zwischen der Kühlwalze und dem Substrat und zu einer verminderten Belastung des Prozessvakuums mit dem Fluid führt. Nachteilig ist hierbei jedoch der hohe technische Aufwand für das Durchführen eines solchen Verfahrens.

### Aufgabenstellung

Der Erfindung liegt daher das technische Problem zugrunde, ein Verfahren zu schaffen, mittels dessen die Nachteile aus dem Stand der Technik überwunden werden. Insbesondere soll mit dem erfindungsgemäßen Verfahren beim Beschichten bandförmiger Substrate ein gegenüber dem Stand der Technik verbesserter Wärmeübergang vom Substrat zur Kühlwalze erzielt werden. Ferner soll das Verfahren mit einfachen technischen Mitteln in bestehende Beschichtungsprozesse integrierbar sein.

Die Lösung des technischen Problems ergibt sich durch die Gegenstände mit den Merkmalen des Patentanspruchs 1. Weitere vorteilhafte Ausgestaltungen der Erfindung ergeben sich aus den abhängigen Ansprüchen.

Beim erfindungsgemäßen Verfahren zum Kühlen eines innerhalb einer Vakuumkammer angeordneten bandförmigen Substrates umschlingt das Substrat eine Kühlwalze nur teilweise. Als bandförmiges Substrat können beispielsweise Kunststofffolien, Metallbänder oder Metallfolien verwendet werden. Dabei wird die nicht mit der Kühlwalze in Kontakt gelangende Oberfläche des Substrates in einem Bereich, in welchem das Substrat die Kühlwalze berührt, mit Partikeln beaufschlagt. Das Beaufschlagen der Substratoberfläche mit Partikeln kann zum Beispiel zum Zwecke des Beschichtens oder des Ätzens der Substratoberfläche erfolgen. Außerdem wird ein dampf- oder gasförmiges Medium auf einen vom bandförmigen Substrat nicht umschlungenen Oberflächenbereich der Kühlwalze geleitet. Eine gegenüber dem Stand der Technik verbesserte Kühlwirkung wird dadurch erreicht, indem die Kühlwalze auf eine Temperatur gekühlt wird, bei der zumindest Bestandteile des auf die Kühlwalze auftreffenden dampf- oder gasförmigen Mediums in den festen Aggregatzustand übergehen. Das auf der Oberfläche der Kühlwalze erstarrte ursprünglich dampf- oder gasförmige Medium gelangt auf diese Weise optimal zwischen Substrat und Kühlwalze, ohne dass ein Großteil des eingebrachten dampf- oder gasförmigen Mediums entweichen kann, wie es mit den im Stand der Technik verwendeten Gasen geschieht. Das auf der Kühlwalze erstarrte Medium wird mit der Kühlwalze bewegt. Erst in dem Bereich, in dem das Substrat mit Partikeln beaufschlagt wird, sorgt die eingetragene Prozesswärme für eine Änderung des Aggregatzustandes des erstarrten Mediums hin zum flüssigen bzw. gas- oder dampfförmigen Aggregatzustand. Auf diese Weise wird eine Erhöhung des Wärmeübergangs vom Substrat zur Kühlwalze realisiert. Die Kühlung des Substrates findet effizienter statt. Dreht sich die Kühlwalze weiter und verlässt das Substrat den Bereich, in welchem das Substrat mit Partikeln beaufschlagt wird, reduziert sich der Wärmeeintrag und das Medium erstarrt wieder auf der Kühlwalze, und zwar noch in einem Bereich, in dem das Substrat die Kühlwalze umschlingt. Beim Weiterdrehen der Kühlwalze wird das erneut erstarrte Medium mit der Kühlwalze transportiert. Das Vakuum der Prozesskammer wird auf diese Weise nicht mit dem Medium belastet. Aufgrund des auf der Kühlwalze erstarrten Mediums ist das erfindungsgemäße Verfahren auch vorteilhaft bei Prozessen mit geringen Bandgeschwindigkeiten einsetzbar.

### Ausführungsbeispiele

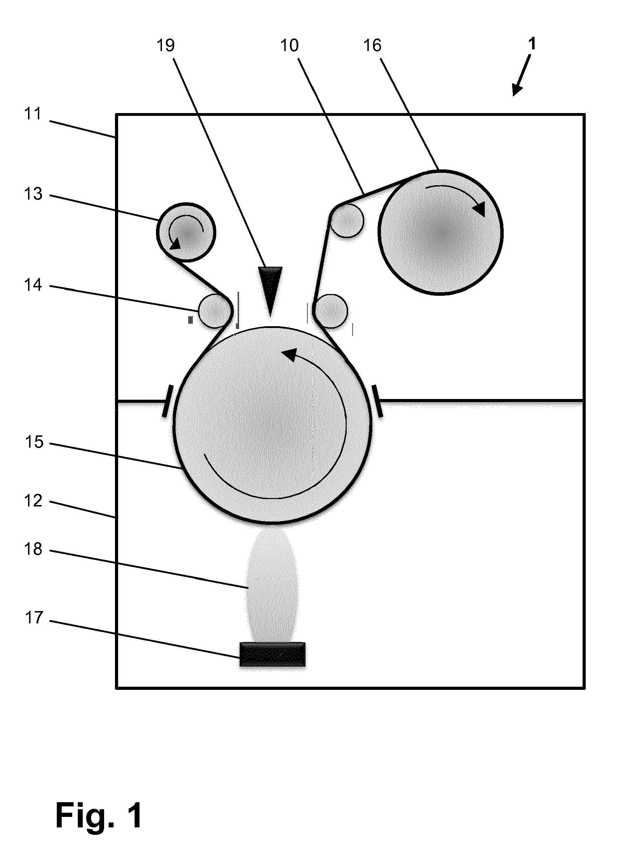

Die vorliegende Erfindung wird nachfolgend anhand von Ausführungsbeispielen näher erläutert. Fig. 1 zeigt eine schematische Darstellung einer Vorrichtung 1, die zum Durchführen des erfindungsgemäßen Verfahrens geeignet ist. Mittels Vorrichtung 1 soll auf einem Substrat 10, welches im Ausführungsbeispiel als 50 µm dicke und 650 mm breite PET-Kunststofffolie ausgebildet ist, eine Aluminiumschicht abgeschieden werden. Vorrichtung 1 umfasst eine Wickelkammer 11 und eine daran angrenzende Prozesskammer 12. Das bandförmige Substrat 10 ist zunächst in der Wickelkammer 11 auf einer Rolle 13 aufgewickelt. Während des Beschichtungsvorgangs wird das Substrat 10 von der Rolle 13 abgewickelt, an einer Umlenkrolle 14 vorbeigeführt bis es eine Kühlwalze 15 teilweise umschlingt. Der runde Querschnitt der Kühlwalze 15 erstreckt sich sowohl innerhalb der Wickelkammer 11 als auch innerhalb der Prozesskammer 12. Alle anderen vorher und nachfolgend benannten Rollen sind nur innerhalb der Wickelkammer 11 angeordnet. Nach dem teilweisen Umschlingen der Kühlwalze 15 wird das Substrat 10 an weiteren Umlenkrollen vorbeigeführt, bis es schließlich auf einer Rolle 16 aufgewickelt wird. Die in den Rollen bzw. Walzen eingezeichneten Pfeile stellen die Drehrichtung des jeweiligen Bauelements dar.

In dem Bereich, in dem das Substrat 10 die Kühlwalze 15 umschlingt, wird die der Kühlwalze 15 abgewandte Oberfläche des Substrates 10 mit Partikeln beaufschlagt. Im Ausführungsbeispiel sind dies schichtbildende Aluminiumpartikel, die von einem Sputter-Magnetron 17, das als Doppelmagnetron ausgebildet ist, erzeugt werden und die in Fig. 1 als Partikelwolke 18 dargestellt sind. Alternativ kann das erfindungsgemäße Verfahren aber auch bei allen anderen bekannten Vakuumbeschichtungsprozessen, wie beispielsweise dem Verdampfen, angewendet werden. Auch können alle anderen bekannten Beschichtungsmaterialien außer Aluminium zum Generieren von Partikeln verwendet werden. Bei einer weiteren alternativen Ausführungsform können die Partikel auch durch einen Ätzprozess, beispielsweise mittels eines Magnetrons, erzeugt werden. Das Beaufschlagen des Substrates 10 mit Partikeln führt zu einem Eintrag von Wärmeenergie in das Substrat 10, die in die Kühlwalze 15 abgeleitet werden soll, um Substratschädigungen zu verhindern.

Zur Verbesserung des wärmeleitenden Übergangs vom Substrat 10 zur Kühlwalze 15 wird innerhalb der Wickelkammer 15 durch einen Einlass 19 Wasserdampf auf die Kühlwalze 15 gesprüht und zwar in einem Oberflächenbereich der Kühlwalze 15, in dem das Substrat 10 die Kühlwalze 15 nicht umschlingt. Erfindungsgemäß wird die Kühlwalze 15 auf eine Temperatur gekühlt, bei der der auf die Oberfläche der Kühlwalze 15 strömende Wasserdampf gefriert und somit in den festen Aggregatzustand übergeht. Der erstarrte Wasserdampf haftet somit an der Oberfläche der Kühlwalze 15 an und wird mit dieser mitbewegt. Im Ausführungsbeispiel wird die Kühlwalze von einem flüssigen Kühlmedium durchströmt, welches eine Temperatur von -23 °C aufweist. Auf der Oberfläche der Kühlwalze wird auf diese Weise eine Temperatur unterhalb von -10 °C eingestellt.

Beim Weiterdrehen der Kühlwalze 15 gelangt der auf der Kühlwalze 15 zu Eis gefrorene Wasserdampf zwischen Substrat 10 und Kühlwalze 15 und ist dort einem Eintrag von Wärmeenergie ausgesetzt, der vom Beaufschlagen des Substrates 10 mit Partikeln infolge des Beschichtungsprozesses herrührt. Dieser Wärmeeintrag führt dazu, dass der zu Eis gefrorene Wasserdampf seinen festen Aggregatzustand wieder verlässt und dann im flüssigen oder gar dampfförmigen Zustand einen großflächigen wärmeleitenden Kontakt zwischen Substrat 10 und Kühlwalze 15 herstellt. Auf diese Weise kann eine gegenüber dem Stand der Technik verbesserte Kühlwirkung erzielt und somit ein Substrat besser vor einer temperaturbedingten Zerstörung geschützt werden.

Nachfolgende Ausführungsbeispiele sollen diese Aussage stützen.

Mit der zuvor beschriebenen Versuchsanordnung wurden Probebeschichtungen mit teilweise unterschiedlichen Versuchsparametern durchgeführt. Bei allen Probebeschichtungen wurden jedoch die Temperatur des Kühlmediums der Kühlwalze 15 auf -23 °C und die Bandgeschwindigkeit des Substrates 10 auf 1 m/min eingestellt.

Bei einem ersten Durchgang, bei dem der Einlass von Wasserdampf zunächst einmal ausgeschaltet blieb, wurde über das Bandlaufwerk der Vorrichtung 1 ein Bandzug von 300 N an das bandförmige Substrat 10 angelegt und der Sputterprozess mittels des Sputter-Magnetrons 17 gestartet. Bei gleichbleibender Bandgeschwindigkeit wurde die Leistung des Sputter-Magnetrons stetig gesteigert, was mit einer zunehmenden thermischen Belastung des Substrates 10 einhergeht, bis thermische Schäden am Substrat 10 in Form sogenannter Wärmefalten zu beobachten vvaren. Diese Wärmefalten stellten sich ab einer Sputterleistung von 18 kW ein. Die Leistung wurde noch bis auf einen Wert von 20 kW gesteigert. Die bei einer Leistung von 20 kW abgeschiedene Aluminium-Schicht auf dem Substrat 10 wies einen Schichtwiderstandswert von 0,5 Ohm auf, gemessen mit einem berührungslos messenden Inline-Widerstandsmessgerät.

Bei einem zweiten Beschichtungsdurchgang wurde die elektrische Leistung des Sputter-Magnetrons 17 gleich auf 20 kW eingestellt und zusätzlich, entsprechend des erfindungsgemäßen Verfahrens, Wasserdampf durch den Einlass 19 auf die Kühlwalze gesprüht. Bei diesem Beschichtungsvorgang konnten keine thermischen Schäden in Form von Wärmefalten am Substrat 10 beobachtet werden. Die Beschichtung konnte ohne Substratschädigung durchgeführt werden. Das abgeschiedene Aluminium wies wie beim ersten Beschichtungsdurchgang einen elektrischen Schichtwiderstand von 0,5 Ohm auf. Eine qualitative Änderung der Schichteigenschaften durch den Einlass des Wasserdampfes konnte nicht festgestellt werden.

Bei einem dritten Beschichtungsdurchgang wurde bei einer konstanten Leistung von 20 kW der Zustrom des Wasserdampfes durch den Einlass 19 abwechselnd geöffnet und wieder geschlossen. Hierbei stellten sich immer dann Wärmefalten am Substrat 10 ein, wenn der Einlass 19 geschlossen war, wohingegen nach jedem Öffnen des Einlasses 19 keine neuen Wärmefalten am Substrat 10 während des Beschichtens ausgebildet wurden.

Anschließend wurde eine gleiche Vorgehensweise wie beim dritten Beschichtungsdurchgang angewendet, jedoch bei einem Bandzug von nur noch 200 N. Auch hierbei wurden bei geschlossenem Einlass 19 Wärmefalten am Substrat 10 während des Beschichtens ausgebildet, wohingegen bei geöffnetem Einlass 19 keine thermische Substratschädigung zu beobachten war.

Erst beim Unterschreiten des Bandzuges unter 100 N konnte beobachtet werden, dass der Effekt zur Vermeidung der thermischen Schäden durch Anwendung des erfindungsgemäßen Verfahrens geringer ausfiel. Es wird vermutet, dass sich bei zu geringem Bandzug kein ausreichendes Gaspolster mehr zwischen Substrat und Kühlwalze ausbilden kann, weil das gasförmige Medium dann wahrscheinlich an den Seiten des bandförmigen Substrates 10 entweicht. Es konnte jedoch bei verschiedenen Versuchsanordnungen mit unterschiedlichen Substratabmessungen ermittelt werden, dass ein Bandzug von mindestens 1 N pro Quadratzentimeter Querschnittsfläche einer verwendeten Folie hinreichend ist, um die positiven Kühleffekte des erfindungsgemäßen Verfahrens auszubilden.

Es sei angemerkt, dass die im Ausführungsbeispiel genannte Kühltemperatur der Kühlwalze 15 von -23 °C lediglich auf das konkrete Ausführungsbeispiel bezogen ist. Bei anderen Ausführungsbeispielen kann eine andere Kühltemperatur erforderlich bzw. hinreichend sein. Die erforderliche Kühltemperatur der Kühlwalze zum Durchführen des erfindungsgemäßen Verfahrens ist zum Beispiel abhängig vom Druck innerhalb der Kammer und von der Art des dampf- oder gasförmigen Mediums, das auf die Kühlwalze aufgetragen wird. Alternativ zum Wasserdampf kann das dampf- oder gasförmige Medium auch andere Substanzen, wie beispielsweise ein Monomer, umfassen. Wird bei einem Beschichtungsprozess beispielsweise ein Monomer für den schichtbildenden Prozess in die Arbeitskammer eingelassen, kann zum Beispiel auch das gleiche Monomer als dampf- oder gasförmiges Medium verwendet werden, das auf die Oberfläche der Kühlwalze aufgetragen wird. Wenn dabei Anteile des Monomers in die Arbeitskammer entweichen, wirkt sich das nicht negativ auf den Beschichtungsprozess aus. Erfindungswesentlich bezüglich der Kühlung der Kühlwalze ist somit lediglich, dass die Kühlwalzentemperatur in Abhängigkeit einer jeweiligen Anlagenkonfiguration auf eine Temperatur eingestellt wird, bei der das auf die Oberfläche der Kühlwalze aufgetragene dampf- oder gasförmige Medium in den festen Aggregatzustand übergeht.

Vorzugsweise wird beim erfindungsgemäßen Verfahren Wasserdampf auf die Kühlwalze aufgetragen. Wasserdampf ist preiswert, lässt sich mit einfachem technischen Aufwand handhaben und erfordert keine aufwändigen Sicherheitsmaßnahmen. Bei einer Verwendung von Wasserdampf als dampf- oder gasförmiges Medium konnten schon bei einer Kühlwalzentemperatur von -5 °C die verbesserten Kühleffekte des erfindungsgemäßen Verfahrens beobachtet werden. Je kühler die Kühlwalze ist, umso besser kann dies für den Kühleffekt eines jeweiligen Substrates sein. Jedoch gilt auch zu beachten, dass jeder zusätzliche Kühlaufwand bezüglich der Kühlwalze die Energiebilanz und somit die Kosteneffektivität eines Beschichtungsprozesses belastet. Vorzugsweise wird daher die Kühlung einer Kühlwalze auf eine Temperatur im Bereich von -5 °C bis -40 °C eingestellt.

Das Ausführungsbeispiel wurde anhand einer Vorrichtung beschrieben, die in eine Wickelkammer und eine Prozesskammer unterteilt ist. Alternativ kann das erfindungsgemäße Verfahren auch mit einer Vorrichtung durchgeführt werden, bei der die Kühlwalze innerhalb nur einer Kammer angeordnet ist.

## Patentansprüche

1. Verfahren zum Kühlen eines innerhalb einer Vakuumkammer (11; 12) angeordneten bandförmigen Substrates (10), welches eine Kühlwalze (15) teilweise umschlingt, wobei die nicht mit der Kühlwalze (15) in Kontakt gelangende Oberfläche des Substrates (10) in einem Bereich, in welchem das Substrat (10) die Kühlwalze (15) berührt, mit Partikeln beaufschlagt wird und wobei ein dampf- oder gasförmiges Medium auf einen vom bandförmigen Substrat (10) nicht umschlungenen Oberflächenbereich der Kühlwalze (15) strömt, **dadurch gekennzeichnet, dass** die Kühlwalze (15) auf eine Temperatur gekühlt wird, bei der zumindest Bestandteile des auf die Kühlwalze (15) auftreffenden dampf- oder gasförmigen Mediums in den festen Aggregatzustand übergehen.

2. Verfahren nach Anspruch 1, **dadurch gekennzeichnet, dass** ein dampf- oder gasförmiges Medium verwendet wird, welches Wasserdampf umfasst.

3. Verfahren nach Anspruch 1, **dadurch gekennzeichnet, dass** ein dampf- oder gasförmiges Medium verwendet wird, welches ein Monomer umfasst.

4. Verfahren nach Anspruch 1, **dadurch gekennzeichnet, dass** das Substrat (10) mit den Partikeln beschichtet wird.

5. Verfahren nach Anspruch 1, **dadurch gekennzeichnet, dass** das Substrat mit den Partikeln geätzt wird.

6. Verfahren nach Anspruch 1, **dadurch gekennzeichnet, dass** eine Kunststofffolie als Substrat (10) verwendet wird.

7. Verfahren nach Anspruch 1, **dadurch gekennzeichnet, dass** ein Metallband oder eine Metallfolie als Substrat verwendet wird.

8. Verfahren nach Anspruch 5, **dadurch gekennzeichnet, dass** der Bandzug des bandförmigen Substrates (10) auf mindestens 1 N pro Quadratzentimeter Querschnittsfläche des Substrates eingestellt wird.

9. Verfahren nach Anspruch 1, **dadurch gekennzeichnet, dass** die Kühlwalze (15) auf eine Temperatur von -5 °C oder tiefer gekühlt wird.
